# EUROPÄISCHE PATENTSCHRIFT

(11) **EP 2 697 824 B1**
(45) Veröffentlichungstag und Bekanntmachung des Hinweises auf die Patenterteilung: **06.02.2019**
(21) Anmeldenummer: 12714231.3
(22) Anmeldetag: 12.04.2012
(51) Int. Cl.: B32B 38/10, H01L 21/67, B32B 43/00, B65G 47/53

(54) **VORRICHTUNG UND VERFAHREN ZUM ÜBERTRAGEN ELEKTRONISCHER BAUTEILE VON EINEM ERSTEN TRÄGER ZU EINEM ZWEITEN TRÄGER**
DEVICE AND METHOD FOR TRANSFERRING ELECTRONIC COMPONENTS FROM A FIRST CARRIER TO A SECOND CARRIER
DISPOSITIF ET PROCÉDÉ DE TRANSFERT DE COMPOSANTS ÉLECTRONIQUES D'UN PREMIER À UN DEUXIÈME SUPPORT

(30) Priorität: 15.04.2011 DE 102011017218
(43) Veröffentlichungstag der Anmeldung: 19.02.2014
(73) Patentinhaber: Mühlbauer GmbH & Co. KG, 93426 Roding (DE)
(72) Erfinder: COURTS, Thomas, 82061 Neuried (DE); NIKLAS, Sigmund, 93199 Zell (DE); SCHILLER, Gerhard, 93426 Roding (DE); DOGARIU, Markus, 93051 Regensburg (DE)
(74) Vertreter: Schmidt, Steffen J.
(86) Internationale Anmeldenummer: PCT/EP2012/001598
(87) Internationale Veröffentlichungsnummer: WO 2012/139766

(56) Entgegenhaltungen:
- EP-A1- 1 764 826
- DE-A1- 19 822 512
- US-A- 4 990 051
- US-A1- 2002 019 074
- US-A1- 2006 237 142
- US-A1- 2007 293 022
- US-A1- 2008 086 874
- US-A1- 2009 242 124
- US-B1- 6 201 306

## Beschreibung

### Hintergrund

Es wird eine Vorrichtung und ein Verfahren zum Übertragen elektronischer Bauteile von einem ersten Träger zu einem zweiten Träger beschrieben. Insbesondere wird eine Vorrichtung und ein Verfahren beschrieben, um ein elektronisches Bauteil mittels einer Ausstoßeinheit von dem ersten Träger zu trennen und direkt auf den zweiten Träger zu übertragen.

Beim Übertragen von elektronischen Bauteilen, insbesondere Chips (engl.: "dies") und insbesondere beim Übertragen von vereinzelten elektronischen Bauteilen besteht allgemein das Problem, dass diese leicht beschädigt werden können und daher mit großer Sorgfalt behandelt werden müssen. Zudem sind elektronische Bauteile einer kontinuierlichen Miniaturisierung unterworfen, so dass die Anforderungen hinsichtlich der Genauigkeit beim Übertragen der elektronischen Bauteile kontinuierlich steigen.

In DE 103 49 847 B3 wird eine Positioniervorrichtung und ein Positionierverfahren für die Übertragung elektronischer Bauteile beschrieben. Dabei ist ein auf einer Trägerfolie angeordneter Halbleiter-Wafer oberhalb und parallel zu einem bandartigen Substrat angeordnet. Der Wafer kann mittels einer Waferhalterung innerhalb der Waferebene verschoben und zusätzlich um eine senkrecht zu der Waferebene stehende Rotationsachse gedreht werden. Eine Ausstoßeinrichtung umfasst eine Ausstechnadel, die mittels einer Bewegung nach unten auf die Rückseite eines abzulösenden Chips wirkt und diesen von der Trägerfolie ablöst. Der von der Trägerfolie abgelöste Chip wird dadurch auf eine Bondposition auf dem bandartigen Substrat abgelegt.

Da der Chip nach dem Ausstechen nur durch die Ausstechnadel geführt wird, besteht die Gefahr, dass sich der Chip während des Ablösens von der Trägerfolie verdreht. In diesen Fall kann der Chip nur ungenau auf der Bondposition platziert werden. Ein Verdrehen des Chips kann insbesondere dann auftreten, wenn die Ausstoßnadel den Chip nicht in der Mitte des Chips berührt oder wenn keine gleichmäßige Klebeverbindung zwischen dem Chip und der Trägerfolie besteht.

Da ein ungenau platziertes elektronisches Bauteile in der Regel als Schlechtteil und somit als Ausschuss anzusehen ist, ist ein möglichst genaues Platzieren des Bauteils wünschenswert.

In der DE 198 40 226 A1 ist ein Verfahren zum Übertragen elektronischer Bauteile von einem Hilfssubstrat auf eine bandförmige Trägervorrichtung offenbart. Weitere Vorrichtungen und Verfahren zum Übertragen von elektronischen Bauteilen, die technologischen Hintergrund zur hier beschrieben Vorrichtung und zum hier beschriebenen Verfahren bilden, werden in den Dokumenten JP 5267451 A, EP 0 565 781 B1 und DE 198 22 512 A1 beschrieben.

In der US 4,990,051 wird eine ähnliche Anordnung beschrieben, hier fehlt jedoch ein bandförmiger zweiter Träger. Dieses Dokument zeigt auch keine Greifereinrichtung, die dazu eingerichtet ist, den ersten Träger zur Auflage zu fördern, um das elektronische Bauteil von dem ersten Träger zu trennen. Vielmehr wird in diesem Dokument ein Unterdruckkreis offenbart, der bewirkt, dass der äußere Rand einer Auflage angehoben wird, wobei gleichzeitig eine Membran aufgrund des anliegenden Unterdrucks mit angehoben wird. Durch das Anheben der Membran wird diese verformt, so dass die Membran von den Kanten des Bauteils abgeschält wird, wobei der weitaus größte Teil des Bauteils noch an der Membran haftet. Dieser Zustand wird hier mit dem Begriff "vor-abgeschält" bezeichnet. Darunter ist jedoch kein "Trennen", also einem vollständigen Separieren des elektrischen Bauteils vom Träger zu verstehen. Vielmehr erfolgt die Feinpositionierung, nachdem der äußere Rand der Auflage angehoben wurde; somit bleibt auch nach dem Anheben eine Verbindung zwischen der Membran und dem Bauteil bestehen. Der Unterdruckkreis trennt das Bauteil von der Membran nicht. Da der äußere Rand der Auflage und die Membran gemeinsam angehoben werden, wird die Membran auch nicht zur Auflage gefördert. Stattdessen liegt hier die Membran stets an der Auflage an. Bei der hier erläuterten Anordnung besteht auch nachdem Ausfahren des Ausstoßstifts eine Verbindung zwischen Membran und Bauteil. Daher kann das Bauteil auch durch das Ausfahren des Ausstoßstifts nicht von der Membran getrennt werden. Insbesondere ist die abgerundete Form des Ausstoßstifts nicht geeignet, die Membran zu durchstoßen, um dadurch ein vollständiges Abschälen der Membran herbeizuführen. Daher ist es stets erforderlich, dass ein Abnahmewerkzeug das Bauteil mittels Unterdruck ansaugt und aktiv entfernt. Dieses Konzept erfordert stets ein Zusammenwirken der Spannvorrichtung und des Abnahmewerkzeugs, da die Spannvorrichtung lediglich ein teilweises Ablösen an den Rändern des Bauteils bewirken kann.

Das Dokument DE 198 22 512 A1 beschreibt ein Schieber, eine Greifereinrichtung fehlt jedoch. Bei dieser Anordnung wird UV-Bestrahlung verwendet, um die Adhäsion der Trägerfolie gegenüber dem Bauteil zu reduzieren.

In den Dokumenten US 2009/0242124 A1 und EP 1 764 826 A1 wird kein Schieber und auch keine Greifereinrichtung offenbart.

Im Dokument US 2002/001907 A1 ist keine Greifereinrichtung offenbart. Ein Abnahmewerkzeug dient dazu, die Bauteile vollständig von der Membran zu trennen. Auch hier wird UV-Strahlung dazu verwendet, um die Adhäsion des Bauteils an der Membran zu verringern.

Im Dokument US 2008/0086874 A1 ist ein Abnahmewerkzeug vorgesehen. Vor dem Ausfahren der Ausstoßstifte wird ein Unterdruck angelegt, so dass eine Bew egung der Membran relativ zur Auflage verhindert wird. Eine Greifereinrichtung, mit der die Membran zur Auflage gefördert wird um das Bauteil von der Membran zu trennen, wäre hier nicht angebracht.

Das Dokument US 2006/0237142 A1 betrifft ein System zum Abschälen von Bauteilen von einer Membran. Bei diesem System wird zuerst Unterdruck angelegt, um Relativbewegungen der Membran zu verhindern. Daher wäre hier eine Greifereinrichtung nicht angebracht, mit der die Membran zur Auflage gefördert wird, um das Bauteil von der Membran zu trennen.

Im Dokument US 6,201,306 B1 wird ein Durchstoßen der Membran und somit ein vollständiges Ablösen der Bauteile von der Membran gezeigt. Damit wird hier einen zu erkennender Fehler dargestellt und ein Alarmsignal ausgegeben.

Das Dokument EP 0 140 126 A1 zeigt dass der erste Träger mit den Chips und ein zweiter Träger mit aufgebrachten Anschlussbahnen relativ zueinander so ausgerichtet werden, dass Lötverbindungen zwischen Löthöckern auf dem Chip und den Anschlussbahnen auf dem zweiten Träger herstellbar sind, wobei die Löthöcker des Chips mit den freien Enden der Anschlussbahnen in Kontakt gebracht bzw. direkt angelegt werden. Dabei ragen die Anschlussbahnen in Aussparungen des zweiten Trägers. Sie liegen also im Inneren bzw. in der gleichen Ebene wie der zweite Träger. Daher lässt dieses Verfahren keinen Spalt zwischen dem Chip und zweiten Träger zu. Das Dokument EP 0 140 126 A1 zeigt auch keine Kappe und/oder zweite Aufnahme, die dazu eingerichtet sind, aus einer ersten Position in eine zweite Position bewegt zu werden, so dass sich der Spalt zwischen dem ersten Träger und dem zweiten Träger verringert. Hier ist auch kein Schieber vorhanden, der dazu eingerichtet ist, von einem Schieber-Aktor relativ zur Auflage ausgefahren zu werden, den an der Auflage anliegenden Träger von der Auflage abzuheben, und ein auf dem ersten Träger vorgesehenes elektronisches Bauteil in Richtung des zweiten Trägers zu bewegen. Schließlich zeigt dieses Dokument keine Greifeinrichtung, die dazu eingerichtet ist, den ersten Träger zu der Auflage zu fördern, um das elektronische Bauteil von dem ersten Träger zu trennen. Dieses Dokument zeigt einen Stempel, der nach dem Löten nach unten bewegt wird. Also gibt es im Dokument EP 0 140 126 A1 auch keinen Schieber bzw. Dorn um das elektronische Bauteil bzw. den Chip in Richtung des zweiten Trägers zu bewegen. Vielmehr bewegt sich der Stempel relativ zu dem Dorn erst nach dem Löten, d.h. wenn der Chip bereits auf dem zweiten Träger angebracht ist. Eine Bewegung des Chips in die Lötposition ist in diesem Dokument nicht beschrieben. Sie erfolgt dort, bevor der Stempel relativ zu dem Dorn bewegt wurde. Der Stempel wird zusammen mit dem angesaugten Träger von dem Lötstempel weg nach unten bewegt. Somit handelt es sich bei dem Stempel mit seinen Vakuumdurchbrüchen nicht um eine Greifereinrichtung, die den Träger zu einer Auflage fördert. Vielmehr liegt der erste Träger bereits vollständig an dem Stempel an. Hier findet keine Bewegung des ersten Trägers zu dem Stempel hin statt. Dieses Dokument D9 zeigt auch nicht, dass eine erste Aufnahme oder einer zweite Aufnahme dazu eingerichtet ist, den ersten Träger bzw. den zweiten Träger zu positionieren.

### Problem

Es besteht somit die Aufgabe, die elektronischen Bauteile mit einer hohen Genauigkeit und Wiederholbarkeit auf den zweiten bandförmigenTräger zu positionieren. Zudem soll eine hohe Durchsatzrate erreicht und die elektronischen Bauteile schonend behandelt werden.

### Vorgeschlagene Lösung

Zur Lösung dieser Aufgabe wird eine Vorrichtung zum Übertragen elektronischer Bauteile von einem ersten Träger zu einem zweiten Träger vorgeschlagen. Die Vorrichtung hat zumindest einen Schieber, der mit zumindest einem Schieber-Aktor verbunden ist. Eine Kappe weist eine Auflage, einen Schieberkanal zur Aufnahme des zumindest einen Schiebers und eine Greifereinrichtung für den ersten Träger auf. Eine erste Aufnahme ist dazu eingerichtet, den ersten Träger an der Auflage zu positionieren, wobei die elektronischen Bauteile an einer von der Auflage abgewandten Seite des ersten Trägers vorgesehen sind. Aufnahme-Positionier- und/oder -Verschiebeaktoren dienen zum horizontalen Bewegen der ersten Aufnahme relativ zu der Kappe. Eine zweite Aufnahme ist dazu eingerichtet, den zweiten Träger zu positionieren. Die erste Aufnahme und die zweite Aufnahme sind so zueinander angeordnet, dass ein Spalt den ersten Träger von dem zweiten Träger trennt. Die Kappe ist dazu eingerichtet, aus einer ersten Position in eine zweite Position bewegt zu werden, so dass sich der Spalt zwischen dem ersten Träger und dem zweiten Träger verkleinert. Eine Positioniereinrichtung dient zum Positionieren der Kappe und des zumindest einen Schiebers relativ zu der ersten Aufnahme sowie zu der zweiten Aufnahme, wobei die Positioniereinrichtung einen Kappen-Positionieraktor umfasst um die mit der Positioniereinrichtung verbundene Kappe in vertikaler Richtung zu verschieben, wobei durch die vertikale Verschiebung sich der Abstand zwischen der Kappe und dem ersten Träger verändert. Der zumindest eine Schieber ist dazu eingerichtet, von dem zumindest einen Schieber-Aktor relativ zur Auflage ausgefahren zu werden, den an der Auflage anliegenden ersten Träger von der Auflage abzuheben, und ein auf dem ersten Träger vorgesehenes elektronisches Bauteil in Richtung des zweiten Trägers zu bewegen. Die Greifereinrichtung ist dazu eingerichtet, den ersten Träger zu der Auflage zu fördern, um das elektronische Bauteil von dem ersten Träger zu trennen.

Ferner wird zur Lösung der genannten Aufgabe ein Verfahren zum Übertragen eines elektronischen Bauteils von einem ersten Träger zu einem zweiten bandförmigen Träger vorgeschlagen. Dieses Verfahren umfasst die Schritte: Positionieren einer Kappe, eines ersten Trägers und eines zweiten Trägers relativ zueinander, so dass zumindest ein in einem Schieberkanal der Kappe vorgesehener Schieber, ein auf den ersten Träger vorgesehenes elektronisches Bauteil sowie eine auf dem zweiten Träger vorgesehene Kontaktfläche entlang einer gemeinsamen Achse angeordnet sind; Bewegen der Kappe aus einer ersten Position in eine zweite Position, um einen Spalt zwischen dem ersten Träger und dem zweiten Träger zu verkleinern; Ausfahren des zumindest einen Schiebers relativ zur Auflage und in Richtung des zweiten Trägers, so dass der an einer Auflage der Kappe anliegende erste Träger von der Auflage abgehoben wird; Trennen des elektronischen Bauteils von dem ersten Träger, indem eine in der Kappe vorgesehene Greifereinrichtung den ersten Träger zurück zur Auflage fördert, und Ausfahren des zumindest einen Schiebers, um das auf dem ersten Träger vorgesehene elektronische Bauteil in Richtung des zweiten Trägers zu bewegen, bis eine Seite des elektronischen Bauteils den zweiten Träger berührt.

Durch das Zusammenspiel von Kappe, Schieber und ersten Träger kann das elektronische Bauteil über eine längere Distanz sicher geführt werden. Dabei verhindern die Haltekräfte des ersten Trägers ein Verdrehen des elektronischen Bauteils. Durch das Zusammenspiel der Greifereinrichtung und des Schiebers kann das zu übertragende elektronische Bauteil zuverlässig von dem ersten Träger getrennt werden. Somit kann das elektronische Bauteil mit einer höheren Genauigkeit auf dem zweiten Träger platziert werden.

Da das elektronische Bauteil nicht nur durch die Bewegung des Schiebers, sondern auch durch die Förderbewegung der Greifereinrichtung von dem ersten Träger getrennt wird, verringert sich auch der auf das elektronische Bauteil wirkende mechanische Stress.

Bei dieser Vorrichtung ist der Spalt zwischen dem ersten Träger und dem zweiten Träger vor dem Übertragen des elektronischen Bauteils verkleinert. Dadurch kann die Bewegung des zumindest einen Schiebers und die Dehnung des ersten Trägers auf ein Minimum reduziert werden. Das Risiko, den ersten Träger beim Abheben von der Auflage zu beschädigen, kann somit reduziert werden.

### Ausgestaltung und Eigenschaften der Vorrichtung und des Verfahrens

Der zumindest eine Schieber und die Kappe können unabhängig voneinander mit einer zur Positionierung der Kappe vorgesehenen Positioniereinrichtung verbunden sein. Entsprechend kann der zumindest eine Schieber, zumindest in Richtung des zweiten Trägers, unabhängig von der Kappe bewegt werden. Alternativ dazu kann der zumindest eine Schieber und der zumindest eine Schieber-Aktor auch direkt an der Kappe befestigt sein.

Zur Steuerung der Vorrichtung kann eine Steuereinheit vorgesehen sein. Die Steuereinheit kann die Ausfahrbewegung des Schiebers beenden sobald die Steuereinheit erkennt, dass das elektronische Bauteil den zweiten Träger oder einen auf den zweiten Träger aufgebrachten Klebstoff berührt. Dabei kann die Steuereinheit auch erkennen, ob das elektronische Bauteil den Klebstoff teilweise oder vollständig verdrängt und den zweiten Träger berührt. Der zweite Träger kann Kontaktflächen aufweisen, die direkt zu kontaktieren sind. Wenn das elektronische Bauteil auf den zweiten Träger aufliegt, bevor die Greifereinrichtung den ersten Träger zur Auflage fördert, wird das elektronische Bauteil während der gesamten Bewegung vom ersten Träger zum zweiten Träger durch die Haltekräfte des ersten Trägers geführt. Auf diese Weise kann ein Verdrehen des elektronischen Bauteils effektiv verhindert werden.

Zumindest ein Sensorelement kann mit der Steuereinheit verbunden sein. Das zumindest eine Sensorelement kann Sensordaten an die Steuereinheit weiterleiten, anhand derer die Steuereinheit ein Berühren des zweiten Trägers oder eines darauf aufgebrachten Klebstoffs durch das elektronische Bauteil erkennt. Das zumindest eine Sensorelement kann dabei als ein Messelement ausgestaltet sein, das die von dem zumindest einen Schieber-Aktor aufgenommene Leistung erfasst. Ferner kann ein Messelement vorgesehen sein das den von dem zumindest einen Schieber zurückgelegten Weg erfasst. Dabei kann die Steuerung durch ein kombiniertes Auswerten der aufgenommenen Leistung und des zurückgelegten Wegs das Aufliegen des elektronischen Bauteils auf dem zweiten Träger mit einer größeren Zuverlässigkeit erkennen, als dies im Vergleich zur isolierten Auswertung eines Parameters möglich wäre.

Durch die Bewegung der Kappe aus der ersten Position in die zweite Position kann der erste Träger gedehnt werden. Ebenso kann das Ausfahren des zumindest einen Schiebers den ersten Träger dehnen.

Der zumindest eine Schieber kann im eingezogenen Zustand von der Kappe umgeben sein. Eine Spitze des zumindest einen Schiebers kann im Wesentlichen im Zentrum der Auflage angeordnet sein. Durch die Anordnung der Spitze des zumindest einen Schiebers im Zentrum der Auflage kann eine gleichmäßige Dehnung des ersten Trägers erreicht werden, wenn die Kappe aus der ersten Position in die zweite Position gebracht wird und / oder wenn der zumindest eine Schieber ausgefahren wird.

Die Greifereinrichtung kann ein Vakuum-/ Unterdruckgreifer sein, wobei die Greifereinrichtung mit einer Untrerdruckquelle verbunden ist. Die Auflage kann zudem Vertiefungen aufweisen. Die Vertiefungen können zum Beispiel rillen-, nuten-, konus- und / oder halbkugelförmig sein. Die Vertiefungen können dabei dazu vorgesehen sein, dass ein Unterdruck zwischen dem ersten Träger und der Auflage aufgebaut werden kann. Dieser Unterdruck kann bewirken, dass der Umgebungsdruck den ersten Träger an die Auflage presst. Die Vertiefungen können mit einer Unterdruckkammer verbunden sein.

Die Greifereinrichtung kann derart ausgestaltet sein, dass der Aufbau des Unterdrucks in einem zentralen Bereich der Auflage verzögert erfolgt. So kann zum Beispiel der Unterdruck zuerst an Vertiefungen aufgebaut werden, die am Rand der Auflage angeordnet sind. Dadurch kann erreicht werden, dass sich das zu übertragende elektronische Bauteil zuerst am Rand des Bauteils von dem ersten Träger löst.

Zum Beispiel kann die Unterdruckkammer eine Form aufweisen, die den Aufbau des Unterdrucks in einem zentralen Bereich der Auflage verzögert. Alternativ oder ergänzend dazu kann vorgesehen sein, dass über den Schieberkanal angesaugte Leckluft den Aufbau des Unterdrucks in dem zentralen Bereich der Auflage verzögert.

Ferner können eine Beleuchtungseinrichtung und eine Kameraeinrichtung vorgesehen sein. Diese können am Gehäuse der Kappe oder an einer Positioniereinrichtung, die zum Positionieren der Kappe relativ zur ersten und zweiten Aufnahme vorgesehen ist, befestigt sein. Dabei kann die Kameraeinrichtung Bilddaten erfassen, die von der Steuereinheit in Korrekturwerte umgewandelt werden können. Die Korrekturwerte können dann zum Positionieren der Kappe und / oder der ersten Aufnahme verwendet werden.

In einem zentralen Bereich der Auflage kann ein Heizelement vorgesehen sein. Dieses Heizelement kann ein Lichtwellenleiter sein, durch den Laserstrahlung oder die Strahlung von einer oder mehrerer Infrarot-Leuchtdioden zum ersten Träger geleitet wird. Die Laserstrahlung oder die Infrarotstrahlung kann den ersten Träger erwärmen und so die Haltekräfte zwischen dem ersten Träger und dem elektronischen Bauteil reduzieren. Ebenso kann das Heizelement auch beabstandet von der Kappe vorgesehen sein und, zum Beispiel mittels Infrarotstrahlung, Wärmeenergie berührungslos zum ersten Träger übertragen. Alternativ oder ergänzend kann ein elektrisches Heizelement auch im Umfeld der Kappe oder der Auflage vorgesehen sein. So kann das Heizelement zum Beispiel an der Positioniereinrichtung angebracht sein.

Die Schieber-Aktoren können zum Beispiel Piezoaktoren sein.

Die Kappe kann durch einen Kappen-Aktor aus der ersten Position in die zweite Position bewegt werden. Der Kappen-Aktor kann zum Beispiel ein Piezoaktor sein.

Es können Kappen-Positionieraktoren vorgesehen sein, um die Kappe relativ zur ersten Auflage und zur zweiten Auflage zu positionieren. Die Kappen-Positionieraktoren könnend dabei für eine vertikale und / oder horizontale Positionierung der Kappe vorgesehen sein. Die Kappen-Positionieraktoren können an der Positioniereinrichtung für die Kappe vorgesehen sein. Die Kappen-Positionieraktoren können zum Beispiel Piezoaktoren sein. Zudem können Kappen-Verfahraktoren vorgesehen sein. Die Kappen-Verfahraktoren können an der Positioniereinrichtung für die Kappe vorgesehen sein.

Ebenso kann die erste Aufnahme und / oder die zweite Aufnahme Positionieraktoren aufweisen. Mit den Aufnahme-Positionieraktoren kann die erste Aufnahme bzw. die zweite Aufnahme relativ zur Kappe und / oder der anderen Aufnahme positioniert werden. Es können Aufnahme-Positionieraktoren für eine vertikale und eine horizontale Positionierung der ersten und / oder der zweiten Aufnahme vorgesehen sein. Ein Aufnahme-Positionieraktor kann dafür vorgesehen sein, die erste Aufnahme um eine vertikale Achse zu drehen. Die Aufnahme-Positionieraktoren können Piezoaktoren sein. Ferner kann die erste und / oder die zweite Aufnahme Verfahraktoren aufweisen.

Sofern zwei oder mehr Schieber vorgesehen sind, kann die Kappe so zum ersten Träger und dem zu übertragenden elektronischen Bauteil positioniert werden, dass eine gedachte Mittellängsachse aller Schieber, das zu übertragende elektronische Bauteil und die Kontaktfläche entlang einer gemeinsamen Achse angeordnet sind.

Der erste Träger kann bereits während dem Positionieren der Kappe relativ zum ersten Träger beziehungsweise dem Positionieren des ersten Trägers relativ zur Kappe an der Auflage anliegen. Ferner kann der erste Träger zumindest nach dem Positionieren der Kappe relativ zum ersten Träger beziehungsweise dem Positionieren des ersten Trägers relativ zur Kappe an der Auflage anliegen.

Während dem Positionieren der Kappe, des ersten Trägers und des zweiten Trägers kann eine Kameraeinrichtung Bilddaten erfassen und an eine Steuereinheit senden. Die Steuereinheit kann dann die Bilddaten in Korrekturwerte umrechnen. Anhand der Korrekturwerte kann dann die horizontale und / oder die vertikale Position der Kappe, des ersten Trägers oder des zweiten Trägers korrigiert werden. Dabei kann die Korrektur erfolgen, wenn sich die Kappe in der ersten Position befindet und / oder der erste Träger an der Auflage anliegt.

Für die vertikale Positionierung der Kappe, des ersten Trägers und / oder des zweiten Trägers kann ergänzend oder alternativ ein Wegmesselement vorgesehen sein. Das Wegmesselement kann Positionsdaten der Kappe, des ersten Träger und / oder des zweiten Trägers an die Steuereinheit senden, die diese in Korrekturwerte umrechnet.

Der zumindest eine Schieber kann relativ zur Auflage und in Richtung des zweiten Trägers ausgefahren werden. Diese Ausfahrbewegung kann durch die Steuereinheit beendet werden, sobald die Steuereinheit erkennt, dass das zu übertragende elektronische Bauteil den zweiten Träger berührt. Falls Klebstoff am zweiten Träger vorgesehen ist, kann die Steuerung außerdem erkennen, dass das elektronische Bauteil den Klebstoff berührt und / oder verdrängt. Somit kann das zu übertragende elektronische Bauteil während der gesamten Bewegung vom ersten Träger zum zweiten Träger durch die Haltekräfte zwischen dem ersten Träger und dem zu übertragenden elektronischen Bauteil geführt werden. Ferner kann das elektronische Bauteil auf den zweiten Träger oder einen darauf vorgesehenen Klebstoff definiert aufgedrückt werden. Dabei kann ein Teil des Klebstoffs durch das elektronische Bauteil verdrängt werden. Dadurch kann eine zuverlässige Verbindung zwischen dem zu übertragenden elektronischen Bauteil und dem zweiten Träger erhalten werden. Der auf dem zweiten Träger vorgesehene Klebstoff kann in Form eines Klebstofftropfens auf der Kontaktfläche des zweiten Trägers bereitgestellt werden.

Nach dem Trennen des elektronischen Bauteils von dem ersten Träger kann die Kappe von der zweiten Position in die erste Position bewegt werden. Während die Kappe aus der zweiten Position in erste Position bewegt wird, kann der zumindest eine Schieber weiterhin das auf dem zweiten Träger aufliegende Bauteil berühren. So kann zum Beispiel der zumindest eine Schieber ausgefahren bleiben. Da dadurch das elektronische Bauteil weiter auf den zweiten Träger gedrückt werden kann, während sich der Spalt zwischen dem ersten Träger und dem zweiten Träger vergrößert, kann sichergestellt werden, dass sich der erste Träger vollständig von dem zu übertragenden elektrischen Bauteil getrennt hat.

Durch das Bewegen der Kappe zurück in die erste Position kann zudem eine Kollision zwischen dem auf den zweiten Träger übertragenen elektronischen Bauteil und den elektronischen Bauteilen am ersten Träger verhindert werden. Insbesondere kann für eine nachfolgende Positionierung, die vor dem Übertragen eines weiteren elektronischen Bauteils vorgesehen ist, ausgeschlossen werden, dass elektronische Bauteile miteinander kollidieren. Ebenso kann ausgeschlossen werden, dass die auf dem ersten Träger vorgesehenen elektronischen Bauteile den auf dem zweiten Träger vorgesehenen Klebstoff berühren.

Während der Bewegung der Kappe aus der zweiten Position in die erste Position kann die Greifereinrichtung den bereits an der Auflage anliegenden ersten Träger weiterhin zur Auflage fördern. Zum Beispiel kann der zwischen dem ersten Träger und der Auflage erzeugte Unterdruck solange aufrechterhalten werden, bis die Kappe die erste Position erreicht hat.

Der zumindest eine Schieber kann eingefahren werden, nachdem die Kappe die erste Position erreicht hat. Ebenso kann ein zeitlicher Versatz zwischen dem Beginn der Bewegung der Kappe und dem Beginn der Einfahrbewegung des zumindest einen Schiebers vorgesehen sein.

Der Verfahrweg des zumindest einen Schiebers kann kleiner als +/- 8 mm sein. Zum Beispiel kann der Verfahrweg des zumindest einen Schiebers +/- 4 mm betragen. Der Abstand zwischen der ersten Position und der zweiten Position der Kappe kann in etwa die Hälfte des Verfahrwegs des zumindest einen Schiebers betragen. Der zumindest eine Schieber kann stufenlos oder in zwei Schritten ausgefahren werden.

Die Greifereinrichtung kann den ersten Träger mittels eines Unterdrucks zur Auflage fördern. Dabei kann die Greifereinrichtung den Unterdruck am äußeren Rand der Auflage zuerst aufbauen. Entsprechend kann der erste Träger zuerst am äußeren Rand der Auflage angesaugt werden. So kann sich der erste Träger zuerst am Rand des zu übertragenden elektronischen Bauteils lösen.

Zur Steuerung der Bewegung des zumindest einen Schiebers kann die von dem oder den Schieber-Aktoren aufgenommene Leistung erfasst werden. Ebenso kann zur Steuerung der Bewegung des zumindest einen Schiebers der von dem oder den Schiebern zurückgelegte Weg erfasst werden. Dabei kann die Bewegung des zumindest einen Schiebers beendet werden, sobald die Steuereinheit erkennt, dass die aufgenommene Leistung und / oder der zurückgelegte Weg einen Schwellenwert überschreiten. Ferner kann die Steuereinheit das Verhältnis zwischen der aufgenommenen Leistung und dem zurückgelegten Weg zur Steuerung der Bewegung des zumindest einen Schiebers verwenden.

### Kurzbeschreibung der Zeichnungen

Weitere Ziele, Merkmale, Vorteile und Anwendungsmöglichkeiten der hier offenbarten Vorrichtung und des hier offenbarten Verfahrens ergeben sich aus der nachfolgenden Beschreibung von nicht einschränkend zu verstehenden Ausführungsbeispielen und den zugehörigen Zeichnungen.
Fig. 1 zeigt ein Ausführungsbeispiel einer Kappe und eines in einem Schieberkanal der Kappe vorgesehenen Schiebers;
Fig. 2 zeigt ein Ausführungsbeispiel einer Vorrichtung zum Übertragen von elektronischen Bauteilen von einem ersten Träger zu einem zweiten Träger;
Die Fig. 3 zeigt ein Verfahren zum Übertragen von elektronischen Bauteilen von einem ersten Träger zu einem zweiten Träger;
Die Fig. 4a - 4f zeigen einen Übertragungsvorgang gemäß eines Ausführungsbeispiels.

### Detaillierte Beschreibung von Ausführungsbeispielen

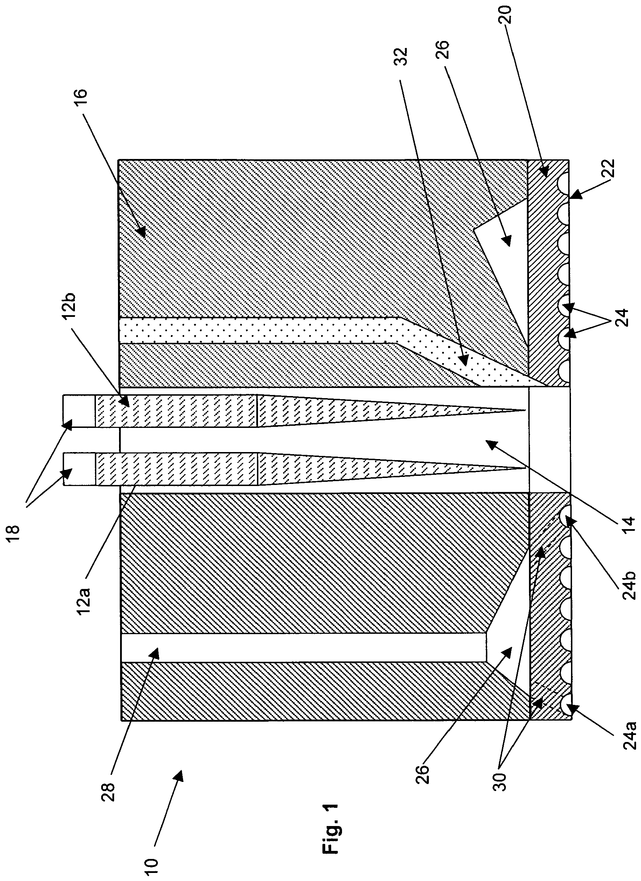

Fig. 1 zeigt ein Ausführungsbeispiel einer Kappe 10. In einem Schieberkanal 14 der Kappe 10 sind zwei Schieber 12a, 12b vorgesehen. Es können aber auch mehr oder weniger Schieber vorgesehen sein. Die Schieber 12a, 12b haben eine Spitze und sind in etwa nadelförmig. Die Kappe 10 umfasst ein Gehäuse 16, wobei der Schieberkanal 14 in etwa in der Mitte des Gehäuses 16 vorgesehen ist. Das in Fig. 1 dargestellte Gehäuse 16 hat im wesentlichen die Form eines Zylinders. In einem Ausführungsbeispiel kann das Gehäuse 16 zum Beispiel die Form eines Kreiszylinders oder eines Quaders aufweisen. Ebenso kann sich das Gehäuse 16 verjüngen oder eine unregelmäßige Form aufweisen.

Die Schieber 12a, 12b sind mit jeweils einem eigenen Schieber-Aktor 18 verbunden. Es ist aber auch möglich, dass beide Schieber mit einem gemeinsamen Schieber-Aktor 18 verbunden sind. Dabei sind die Schieber-Aktoren 18 nicht auf einen bestimmten Aktor-Typ festgelegt. So können zum Beispiel Piezoaktoren verwendet werden. Ebenso können zum Beispiel auch elektromagnetische, pneumatische oder hydraulische Aktoren verwendet werden.

An der Kappe 10 ist zudem eine Greifereinrichtung 20 vorgesehen. Die Greifereinrichtung 20 kann dabei, so wie in Fig. 1 dargestellt, mit dem Gehäuse 16 verbunden sein, oder als integraler Teil des Gehäuses 16 ausgestaltet sein. Die Greifereinrichtung 20 kann zum Beispiel als Unterdruckgreifer, Magnetgreifer oder als elektrostatischer Greifer ausgeführt sein.

In Fig. 1 ist eine Greifereinrichtung 20 dargestellt die mit Unterdruck arbeitet. Dabei ist die Greifereinrichtung 20 über eine Unterdruckleitung 28 mit einer nicht dargestellten Unterdruckquelle, zum Beispiel einer Vakuumpumpe, verbunden.

Bei dem in Fig. 1 dargestellten Ausführungsbeispiel ist an dem unteren Ende der Greifereinrichtung 20 eine Auflage 22 vorgesehen. Ungefähr im Zentrum der Greifereinrichtung 20 und der Auflage 22 ist in Verlängerung zum Schieberkanal 14 eine Aussparung vorgesehen, die ein Ausfahren der Schieber 12a, 12b durch den Schieberkanal 14 ermöglicht.

Die Greifereinrichtung 20 weist eine Mehrzahl von im Querschnitt etwa halbkreisförmigen Vertiefungen 24 auf, die in der Auflage angeordnet sind. Die Vertiefungen 24 können zum Beispiel rillen-, nuten-, konus- oder halbkugelförmig sein. Es ist auch möglich, dass einige Vertiefungen eine erste Form und andere Vertiefungen eine davon abweichende zweite Form aufweisen. Die Vertiefungen 24 können ferner miteinander verbunden oder separiert voneinander ausgeführt sein. Ebenso kann die Greifereinrichtung 20 aus einem luftdurchlässigen Material, zum Beispiel aus einem luftdurchlässigen Schaumstoff, gebildet sein.

Die Vertiefungen 24 der Greifereinrichtung 20 sind über die in Fig. 1 gestrichelt dargestellten Verteilungsleitungen 30 mit einer Unterdruckkammer 26 verbunden. Die Unterdruckkammer 26 kann als Hohlraum in der Greifereinrichtung 20, in dem Gehäuse 16 oder wie in Fig. 1 dargestellt, als ein durch die Greifereinrichtung 20 und das Gehäuse 16 gebildeter Hohlraum ausgebildet sein.

Die Unterdruckkammer 26 ist im vorliegend gezeigten Beispiel der Vorrichtung ringförmig und umschließt den Schieberkanal 14 teilweise oder vollständig. Ebenso kann eine Mehrzahl von separaten Unterdruckkammern vorgesehen sein.

Bei dem in Fig. 1 dargestellten Ausführungsbeispiel ist die Unterdruckkammer 26 derart gestaltet, dass der Aufbau des Unterdrucks in einem zentralen Bereich der Auflage 22 verzögert erfolgt.

Die in Fig. 1 dargestellte Unterdruckkammer 26 weist eine im Wesentlichen dreieckige Querschnittsfläche auf. Die längste Seite des Dreiecks ist der Auflage 22 zugewandt und der betragsmäßig kleinste Winkel des Dreiecks ist dem Schieberkanal 14 zugewandt. Der Anschluss der Unterdruckleitung 28 ist an der der Auflage 22 abgewandten Kante der Unterdruckkammer 26 vorgesehen.

Die Verzögerung des Druckaufbaus im zentralen Bereich der Auflage 22 ergibt sich daraus, dass über den Schieberkanal 14 Leckluft angesaugt wird. Entsprechend muss im zentralen Bereich der Auflage 22 wesentlich mehr Luft abgesaugt werden als am Rand der Auflage 22. Somit wird der Unterdruck zuerst am Rand der Auflage 22 und erst danach im zentralen Bereich der Auflage 22 aufgebaut.

Bei dem in Fig. 1 dargestellten Ausführungsbeispiel ist ein Heizelement vorgesehen. Das Heizelement umfasst einen Lichtwellenleiter 32. Der Lichtwellenleiter 32 ist dabei so angeordnet, dass die aus dem Lichtwellenleiter 32 ausgekoppelte Strahlung durch den Schieberkanal 14 und / oder die Aussparung in der Greifereinrichtung 20 auf einem im Bereich der Auflage 22 angeordneten ersten Träger 68 treffen kann. Dies ermöglicht es, den ersten Träger 68 gezielt zu erwärmen. Dabei können eine Laserlichtquelle sowie eine oder mehrere Infrarot-Leuchtdioden vorgesehen sein, um die Strahlungsenergie in den Lichtwellenleiter 32 einzukoppeln.

In einem nicht dargestellten Ausführungsbeispiel kann das Heizelement neben der Kappe 10, zum Beispiel an einer Positioniereinrichtung 11, vorgesehen sein, so dass keine direkte Verbindung zwischen Heizelement und Kappe 10 besteht. Dabei kann die Wärmeenergie berührungslos, zum Beispiel durch Infrarot-Strahlung übertragen werden.

Alternativ oder zusätzlich kann auch ein elektrischer Heizwiderstand vorgesehen sein, der in einem zentralen Bereich der Auflage 22, der Greifereinrichtung 20, und / oder des Gehäuses 16 angeordnet ist. Ebenso kann ein Heizwiderstand an den Schiebern 12a, 12b vorgesehen sein.

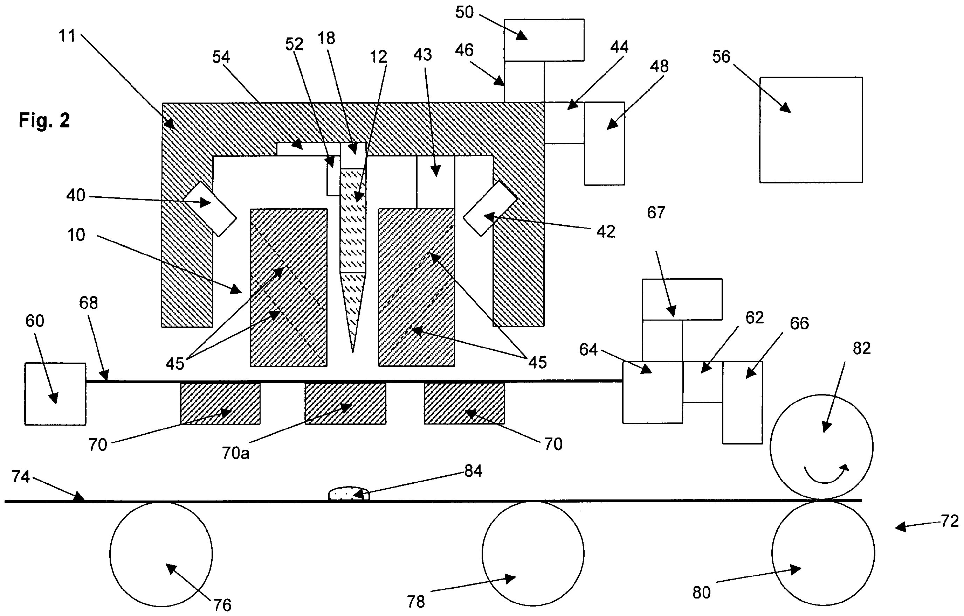

In Fig. 2 ist eine Vorrichtung zum Übertragen elektronischer Bauteile von einem ersten zu einem zweiten Träger dargestellt. Die in Fig. 2 dargestellte Kappe 10 kann der in Verbindung mit Fig. 1 beschriebenen Kappe 10 entsprechen. Aus Gründen der besseren Übersichtlichkeit sind jedoch nicht alle Details der Kappe 10 in der Fig. 2 dargestellt.

Die Kappe 10 ist an der Positioniereinrichtung 11 angebracht, wobei die Positioniereinrichtung 11 dazu vorgesehen ist, die Kappe 10 relativ zu einer ersten Aufnahme 60 und einer zweiten Aufnahme 72 zu positionieren. Die Einheit aus Kappe 10, den zumindest einen Schieber 12, sowie der Positioniereinrichtung 11 kann dabei als Ausstoßeinheit bezeichnet werden. Ein Kappen-Aktor 43 kann die Kappe 10 von einer ersten Position in eine zweite Position bewegen. Die Kappe 10 kann somit relativ zur Positioniereinrichtung 11 bewegt werden.

Bei dem in Fig. 2 dargestellten Beispiel ist der zumindest eine Schieber 12 direkt mit der Positioniereinrichtung 11 verbunden. Der Schieber-Aktor 18 ermöglicht dabei eine Bewegung des Schiebers 12 relativ zur Positioniereinrichtung 11. Der Kappen-Aktor 43 und der Schieber-Aktor 18 können dabei den Schieber 12 und die Kappe 10 entlang einer gemeinsamen Achse bewegen. Die gemeinsame Achse kann zum Beispiel der Längsachse des Schiebers 12 entsprechen oder parallel zu dieser sein.

An der Positioniereinrichtung 11 sind eine Beleuchtungseinrichtung 40 und eine Kameraeinrichtung 42 vorgesehen. Dabei sind in dem Gehäuse 16 der Kappe 10 Aussparungen oder Kanäle vorgesehen, so dass die Beleuchtungseinrichtung 40 den ersten Träger 68 beleuchten und die Kameraeinrichtung 42 Bilddaten erfassen kann. In Fig. 2 sind die Aussparungen oder die Kanäle durch die gestrichelten Linien 45 angedeutet. Die Aussparungen oder die Kanäle können dabei derart angeordnet sein, dass die Kameraeinrichtung 42 lediglich dann Bilddaten eines zu übertragenden elektronischen Bauteils erfassen kann, wenn sich die Kappe 10 in der ersten Position befindet. Eine Befestigung der Beleuchtungseinrichtung 40 und der Kameraeinrichtung 42 an der Positioniereinrichtung 11 bietet dabei allerdings den Vorteil, dass die beim Bewegen der Kappe 10 aus der ersten Position in die zweite Position zu bewegende Masse gering gehalten werden kann.

Alternativ zu einer Befestigung der Beleuchtungseinrichtung 40 und der Kameraeinrichtung 42 an der Positioniereinrichtung 11 können die Beleuchtungseinrichtung 40 und die Kameraeinrichtung 42 auch direkt an der Kappe 10 befestigt sein.

Um die Kappe 10 und den zumindest einen Schieber 12 relativ zu einer ersten Aufnahme 60 sowie zu einer zweiten Aufnahme 72 zu positionieren ist die bereits erwähnte Positioniereinrichtung 11 vorgesehen. Diese Positioniereinrichtung 11 umfasst einen ersten Kappen-Positionieraktor 44, einen zweiten Kappen-Positionieraktor 46 und einen dritten Kappen-Positionieraktor (nicht dargestellt). Dabei kann mit dem ersten Kappen-Positionieraktor 44 zumindest ein Teil der Positioniereinrichtung 11 sowie die mit der Positioniereinrichtung verbunden Kappe 10 in vertikaler Richtung und mit den zweiten und dritten Kappen-Positionieraktoren 46 in horizontaler Richtung verschoben werden. Durch eine vertikale Verschiebung kann der Abstand zwischen der Kappe 10 und dem ersten Träger 68 verändert werden. Die Kappen-Positionieraktoren 44, 46 können zum Beispiel aber auch elektromagnetische-, pneumatische-, hydraulische- und / oder Piezoaktoren sein.

Bei dem in Fig. 2 dargestellten Ausführungsbeispiel sind zudem Kappen-Verfahraktoren 48, 50 vorgesehen. Dabei kann mit einem ersten Kappen-Verfahraktor 48 zumindest ein Teil der Positioniereinrichtung 11 sowie die mit der Positioniereinrichtung verbunden Kappe 10 und der im Schieberkanal der Kappe 10 aufgenommene zumindest eine Schieber 12 in vertikaler Richtung und mit den zweiten und dritten (nicht dargestellt) Kappen-Verfahraktoren 50 in horizontaler Richtung verschoben werden.

Falls Kappen-Positionieraktoren 44, 46 und Kappen-Verfahraktoren 48, 50 vorgesehen sind, können die Kappen-Verfahraktoren 48, 50 für eine grobe Positionierung und die Kappen-Positionieraktoren 44, 46 für eine feine Positionierung verwendet werden. Sind nur Kappen-Positionieraktoren 44, 46 vorgesehen, erfolgt die Positionierung einstufig. Sind zusätzlich Kappen-Verfahraktoren 48, 50 vorgesehen, erfolgt die Positionierung zweistufig. Dabei kann für eine Richtung eine einstufige Positionierung und für eine andere Richtung eine zweistufige Positionierung vorgesehen sein.

Ferner sind an der Positioniereinrichtung 11 Sensorelemente vorgesehen. Bei dem in Fig. 2 dargestellten Ausführungsbeispiel sind dies ein Wegmesselement 52 und ein Leistungsmesselement 54. Dabei erfasst das Wegmesselement 52 den von dem Schieber 12 zurückgelegten Weg. Das Leistungsmesselement 54 erfasst die von dem Schieber-Aktor 18 aufgenommene Leistung. Alternativ zu dem Leistungsmesselement 54 kann zwischen dem Schieber 12 und dem Schieber-Aktor 18 auch ein Kraftmesselement vorgesehen sein.

Im Bereich der Auflage 22 ist die erste Aufnahme 60 vorgesehen, die separat von der Positioniereinrichtung 11 sowie der Kappe 10 bewegt werden kann. Bei dem in Fig. 2 dargestellten Ausführungsbeispiel ist die erste Aufnahme 60 unterhalb der Kappe 10 angeordnet.

Wie bei der Positioniereinrichtung 11 kann auch für die erste Aufnahme 60 eine einstufige oder zweistufige Positionierung vorgesehen sein. Entsprechend können Verfahraktoren und / oder Positionieraktoren vorgesehen sein. Bei dem in Fig. 2 dargestellten Ausführungsbeispiel ist ein erster Aufnahme-Positionieraktor 62, ein zweiter Aufnahme-Positionieraktor 64, ein erster Aufnahme-Verschiebeaktor 66 und ein zweiter Aufnahme-Verschiebeaktor 68 vorgesehen. Dabei ermöglichen der erste und zweite Aufnahme-Positionieraktor 62, 64 sowie der erste und zweite Aufnahme-Verschiebeaktor 66, 68 eine horizontale Bewegung der ersten Aufnahme 60. Die Bewegungen der ersten Aufnahme 60 können dabei relativ zu der Kappe 10 erfolgen. Ferner können Aktoren (nicht dargestellt) vorgesehen sein die eine Drehbewegung des ersten Trägers 68 ermöglichen. So kann zum Beispiel der erste Träger 68 um eine vertikale Achse gedreht werden, so dass die elektronischen Bauteile vor dem Übertragen auf den zweiten Träger 74 exakt ausgerichtet werden können. In einem Sonderfall kann zudem eine vertikale Positionierung der ersten Aufnahme 60 vorgesehen sein. Entsprechend können weitere Aktoren vorgesehen sein.

Die erste Aufnahme 60 nimmt einen ersten Träger 68 auf. An einer der Auflage 22 entgegengesetzten Seite des ersten Trägers 68 sind elektronische Bauteile 70 vorgesehen. In einem Ausführungsbeispiel kann der erste Träger 68 eine Waferfolie sein. Die Waferfolie kann dabei auf einen Spannring montiert sein. Die elektronischen Bauteile können vereinzelte Dies sein, die vor dem Vereinzeln auf die Waferfolie aufgebracht wurden.

Die zweite Aufnahme 72 kann einen zweiten Träger 74 aufnehmen. Die zweite Aufnahme 72 umfasst eine erste, zweite und dritte Auflagerolle 76, 78, 80 und eine Antriebsrolle 82. Die Auflagerollen 76, 78, 80 sind dabei nicht auf eine Rollenform festgelegt. So können zum Beispiel auch Glashalbzylinder vorgesehen sein.

Wie bei der Positioniereinrichtung 11 und der ersten Aufnahme 60 kann für die zweite Aufnahme 72 eine einstufige oder zweistufige Positionierung vorgesehen sein. Entsprechend können Verfahraktoren und Positionieraktoren vorgesehen sein. Bei dem in Fig. 2 dargestellten Ausführungsbeispiel ist allerdings lediglich eine einstufige horizontale Positionierung des zweiten Trägers möglich. Es können jedoch weitere Aktoren vorgesehen sein, um die zweite Aufnahme 72 ein- oder zweistufig in vertikaler und / oder einer zweiten horizontalen Richtung zu positionieren.

In einem Ausführungsbeispiel ist der zweite Träger 74 ein Substratband. Das Substratband kann zum Beispiel als Trägermaterial bei der Herstellung von Chipkarten oder Smartcards verwendet werden. Der zweite Träger 74 kann eine Kontaktfläche aufweisen, auf der ein zu übertragendes elektronisches Bauteil 70a zu platzieren ist. Die Kontaktfläche kann dabei elektrische Kontaktierungen aufweisen. Die Kontaktfläche kann aber ebenso gut eine elektrisch nicht leitende Struktur sein, die eine Positionierung des zweiten Trägers 74 oder ein Ausrichten der zu übertragenden elektronischen Bauteile erleichtert. Auf den zweiten Träger 74 kann zudem Klebstoff in Form eines Klebstofftropfens 84 auf der Kontaktfläche oder in Form einer Klebstoffschicht vorgesehen sein.

Die in Fig. 2 dargestellte Vorrichtung weist ferner eine Steuereinheit 56 auf. Diese Steuereinheit ist mit den in Fig. 1 und 2 dargestellten Aktoren 18, 43, 44, 46, 48, 50, 62, 64, 66, 67, 82, den Sensorelementen 52, 54, der Beleuchtungseinrichtung 40 und der Kameraeinrichtung 42 verbunden. Die Steuereinheit 56 kann anhand der von der Kameraeinrichtung 42 erfassten Bilddaten Korrekturwerte berechnen, die für die Positionierung der Kappe 10 und / oder der ersten Aufnahme 60 verwendet werden können. Zudem kann die Steuereinheit die Aktoren 18, 43, 44, 46, 48, 50, 62, 64, 66, 67, 82 direkt oder indirekt ansteuern und so die Elemente der dargestellten Vorrichtung in der notwendigen zeitlichen Abfolge in eine jeweils gewünschte Position bringen. Außerdem kann die Steuereinheit die von den Messelementen 52 und 54 erfassten Daten auswerten und auf Grundlage der Daten bestimmen, ob das zu übertragende elektronische Bauteil 70a auf den zweiten Träger aufliegt oder ob ein weiteres Ausfahren des Schiebers 12 erforderlich ist.

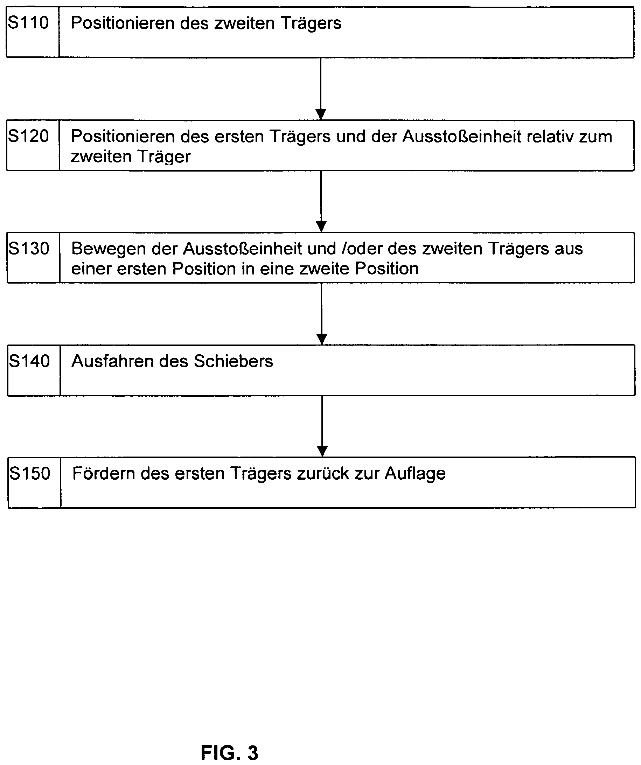

Fig. 3 zeigt ein Verfahren zum Übertragen von elektronischen Bauteilen von einem ersten Träger zu einem zweiten Träger.

In Schritt S110 wird der zweite Träger 74 positioniert. Bei der in Fig. 2 dargestellten Ausführungsform erfolgt dies indem die Steuereinheit 56 die Antriebsrolle 82 ansteuert, so dass eine Kontaktfläche und gegebenenfalls ein auf die Kontaktfläche aufgebrachter Klebstofftropfen zwischen der ersten und zweiten Auflagerolle 76, 78 angeordnet ist.

In Schritt S120 wird die Kappe 10 sowie der erste Träger 68 relativ zum zweiten Träger positioniert. Dazu kann die Steuereinheit 56 die von der Kameraeinrichtung 42 empfangenen Daten auswerten und die Verfahraktoren und die Positionieraktoren der Positionierungseinrichtung 11 und der ersten Aufnahme 60 entsprechend ansteuern, so dass der zumindest eine Schieber 12, ein zu übertragendes elektronisches Bauteil 70a und die Kontaktfläche entlang einer Achse angeordnet sind. Zudem können die Kappe 10 bzw. die erste Aufnahme relativ zueinander positioniert werden, so dass der erste Träger 68 unterhalb der Auflage 22 angeordnet ist. Dabei kann eine Seite des ersten Trägers 68 an der Auflage 22 anliegen.

Die Schritte S110 und S120 müssen nicht nacheinander ausgeführt werden. So können zum Beispiel der erste und zweite Träger sowie die Kappe 10 auch gleichzeitig positioniert werden. Ebenso kann vor dem Schritt 110 die Kappe 10 und die erste Aufnahme 60 grob vorpositioniert werden und nach dem Positionieren des zweiten Trägers 74 können die Kappe 10 und der erste Träger 68 dann exakt positioniert werden.

In einem weiteren Schritt S130 wird die Kappe 10 und / oder der zweite Träger 74 aus einer ersten Position in einen zweite Position bewegt. Da bei dem in Fig. 2 dargestellten Ausführungsbeispiel der zweite Träger 74 lediglich in einer horizontalen Richtung bewegt werden kann, erfolgt dieser Schritt bei dem dargestellten Ausführungsbeispiel durch eine Bewegung der Kappe 10 in Richtung des zweiten Trägers 74. Dabei kann die erste Aufnahme 60 in der vorherigen Position bleiben oder, in gleicher Weise wie die Kappe 10, in Richtung des zweiten Trägers 74 bewegt werden. Bleibt die erste Aufnahme 60 in der vorherigen Position, kann der erste Träger 68 durch die Bewegung der Kappe 10 gedehnt werden. Dabei wird ein Spalt zwischen dem ersten Träger 68 und dem zweiten Träger 74 verkleinert.

Anschließend wird in Schritt S140 der zumindest eine Schieber 12 in Richtung des zweiten Trägers 74 ausgefahren, so dass zumindest die Spitze des zumindest eine Schiebers 12 aus dem Schieberkanal 14 ragt. Dabei berührt der zumindest eine Schieber 12 den ersten Träger 68 und hebt diesen von der Auflage 22 ab, so dass ein Freiraum zwischen der Auflage 22 und dem ersten Träger 68 entsteht. Dadurch wird der erste Träger 68 im Bereich um die Auflage 22 gedehnt. Der zumindest eine Schieber 12 kann dabei den ersten Träger 68 teilweise oder vollständig durchstechen. Durch die Ausfahrbewegung wird das an der der Auflage 22 gegenüberliegenden Seite des ersten Trägers 68 vorgesehene elektronische Bauteil 70a in Richtung des zweiten Trägers 74 bewegt.

Dabei kann das zu übertragende elektronische Bauteil 70a soweit bewegt werden, bis eine Seite des elektronischen Bauteils 70a den zweiten Träger 74 und / oder einen eventuell auf den zweiten Träger aufgebrachten Klebstofftropfen 84 berührt. Um eine zuverlässige Verbindung zwischen dem zweiten Träger 74, dem Klebstofftropfen 84 und dem übertragenen elektrischen Bauteil zu gewährleisten, kann das elektronische Bauteil so weit in den Klebstofftropfen 84 gedrückt werden, dass dadurch Klebstoff verdrängt wird. Ein Berühren oder ein Verdrängen kann von der Steuereinheit 56 anhand der vom Wegmesselement 52 und dem Leistungsmesselement 54 erfassten Daten erkannt werden, da bedingt durch den mechanischen Widerstand des zweiten Trägers 74 die Leistungsaufnahme des Schieber-Aktors 18 ansteigt, während sich der Schieber 12 nicht mehr oder nur noch unwesentlich bewegt. Entsprechend überwacht die Steuereinheit 56 die Wegmesswerte und die Leistungsmesswerte oder deren Veränderungen.

Im folgenden Schritt S150 wird der erste Träger 68 durch die Greifereinrichtung 20 zurück zur Auflage 22 gefördert. Dazu kann zum Beispiel Unterdruck verwendet werden. Der Unterdruck bewirkt, dass die im Freiraum zwischen der Auflage 22 und dem ersten Träger 68 vorhandene Luft abgesaugt wird, so dass der Druck in dem Freiraum zwischen dem ersten Träger 68 und der Auflage 22 geringer ist als der Druck unter dem ersten Träger 68. Infolgedessen wird der erste Träger 68 durch den Umgebungsdruck zur Auflage 22 gedrückt.

Da der zumindest eine Schieber 12 weiterhin das elektronische Bauteil 70a auf den zweiten Träger 74 drückt oder zumindest das elektronische Bauteil in einer von der Auflage 22 beabstandeten Position hält, wird eine Klebeverbindung zwischen dem elektronischen Bauteil 70a und dem ersten Träger 68 gelöst.

Anschließend kann die Kappe 10 in die erste Position bewegt werden und der Schieber 12 kann vollständig eingefahren werden und ein weiteres elektronisches Bauteil kann mit den vorstehend erläuterten Schritten übertragen werden.

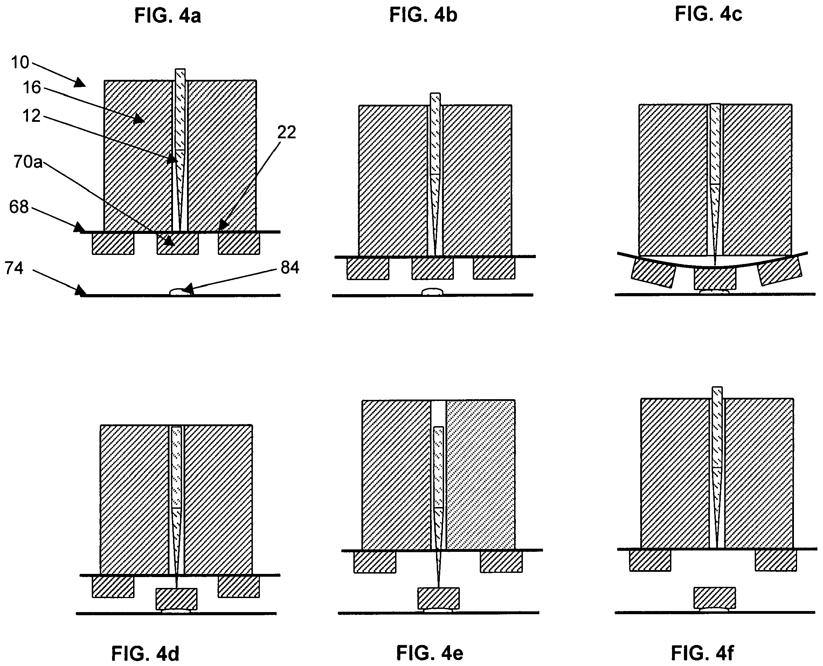

Die Fig. 4a - 4f zeigen einen Übertragungsvorgang gemäß eines Ausführungsbeispiels.

Wie in Fig. 4a dargestellt, wird die Kappe 10 und der erste Träger 68 über dem zweiten Träger 74 positioniert, wobei die Auflage 22 den ersten Träger 68 berührt, oder der erste Träger 68 in einem geringen Abstand unterhalb der Auflage 22 angeordnet ist. Die Kappe 10 befindet sich in der ersten Position. Durch Öffnungen im Gehäuse 16 kann von der Kameraeinrichtung 42 ein Bild von der Rückseite des zu übertragenden elektronischen Bauteils 70a aufgenommen werden. Dabei beleuchtet die Beleuchtungseinrichtung 40 durch den ersten Träger 68 die Rückseite des zu übertragenden elektronischen Bauteils 70a. Das von der Kameraeinrichtung 42 aufgenommenen Bild, bzw. die Bilddaten werden von der Steuereinheit 56 in Korrekturwerte zum horizontalen Positionieren der Kappe 10 umgerechnet. Diese Korrekturwerte können gegebenenfalls für eine Positionskorrektur der Kappe 10 und der ersten Aufnahme 60 genutzt werden. Nach der Positionierung, beziehungsweise nach der Korrektur, befindet sich der Schieber 12 und das zu übertragende elektronische Bauteil 70a über der Kontaktfläche.

In Fig. 4b ist die Kappe 10 in der zweiten Position dargestellt. Dabei wurde durch die Bewegung der Kappe 10 in Richtung des zweiten Trägers 74 der erste Träger 68 vorgespannt. Dabei kann der Abstand zwischen der Kappe 10 und dem zweiten Träger 74 minimal sein. Der Schieber 12 hat dabei noch keinen Kontakt mit dem zu übertragenden elektronischen Bauteil 70a. Es ist aber auch möglich, dass der zumindest eine Schieber 12 bereits an dem ersten Träger 68 anliegt.

In Fig. 4c ist der Schieber 12 in einem ausgefahrenen Zustand dargestellt. Durch die Ausfahrbewegung berührt der Schieber 12 den ersten Träger 68, durchsticht diesen teilweise oder vollständig und berührt, sofern der Schieber 12 den ersten Träger vollständig durchsticht, das zu übertragende elektronische Bauteil 70a. Der erste Träger 68 wird von der Auflage 22 abgehoben und gespannt. Der Schieber 12 wird dabei soweit ausgefahren, bis das zu übertragende elektronische Bauteil 70a den Klebstofftropfen 84 berührt. Durch das Verdrängen des Klebstofftropfens 84 und den mechanischen Widerstand des zweiten Trägers steigt die Leistungsaufnahme des Schieber-Aktors 18. Dies wird von dem Leistungsmesselement 54 erfasst. Die Steuereinheit 56 beendet die Ausfahrbewegung des Schiebers, wenn die Leistungsaufnahme des Schieber-Aktors 18 einen Schwellenwert erreicht hat. Durch ein Erfassen der vom Schieber-Aktor 18 aufgenommen Leistung kann ein Zerbrechen oder ein Beschädigen des zu übertragenden elektronischen Bauteils 70a verhindert werden.

In Fig. 4d ist das zu übertragende elektronische Bauteil 70a und die Kappe 10 nach dem Trennen des zu übertragenden elektronischen Bauteils 70a von dem ersten Träger 68 dargestellt. Das zu übertragende elektronische Bauteil 70a wird durch den Schieber 12 in Position gehalten. Zudem wird die Greifereinrichtung 20 aktiviert. Bei dem beschriebenen Ausführungsbeispiel wird dazu ein Unterdruck zwischen dem ersten Träger 68 und der Auflage 22 erzeugt. Dadurch wird der erste Träger 68 zurück zur Auflage 22 gefördert. Durch diesen Ansaugvorgang wird das zu übertragende elektronische Bauteil 70a von dem ersten Träger 68 getrennt. Dabei wird der Unterdruck vom äußeren Rand der Auflage 22 hin zum Zentrum der Auflage 22 aufgebaut. Um die Haltekräfte zwischen dem zu übertragende elektronische Bauteil 70a und dem ersten Träger 68 zu reduzieren, kann vor dem Aktivieren der Greifereinrichtung 20 mittels eines Heizelements der erste Träger 68 erwärmt werden. Dies kann zum Beispiel mittels der durch den Lichtwellenleiter 32 eingebrachten Laserstrahlung oder durch eine dauerhafte Erwärmung mittels Heizstrahler erfolgen.

Anschließend wird die Kappe 10 in die erste Position bewegt. In Fig. 4e ist die Kappe 10 dargestellt, nachdem sie die erste Position erreicht hat. Während die Kappe 10 in die erste Position bewegt wird, bleibt die Spitze des Schiebers 12 in Kontakt mit der Oberfläche des zu übertragenden elektronischen Bauteils 70a. Nachdem die Kappe 10 die erste Position erreicht hat, wird die Greifereinrichtung 20 deaktiviert. Dabei bleibt der Schieber 12 ausgefahren, so dass der Schieber 12 weiterhin das zu übertragende elektronische Bauteil 70a auf den zweiten Träger 74 drückt.

Abschließend wird der Schieber 12 von dem zu übertragenden elektronischen Bauteil 70a abgehoben und eingefahren. Der Schieber 12 wird dabei durch den ersten Träger 60 zurückgezogen. Dies ist in Fig. 4f dargestellt. Nachdem der Schieber 12 vollständig in dem Schieberkanal 14 aufgenommen ist, kann mit der Vorrichtung ein weiteres elektronisches Bauteil übertragen werden. Also das in Verbindung mit den Fig. 4a bis 4f beschriebene Verfahren erneut ausgeführt werden.

Die vorstehend erläuterten Details der Verfahren und der Vorrichtung sind zwar im Zusammenhang dargestellt; es sei jedoch darauf hingewiesen, dass sie, zumindest soweit einzelne auf sie gerichtete Patentansprüche aufgestellt sind, auch unabhängig von einander sind und auch frei miteinander kombinierbar sind. Die in den Figuren ersichtlichen Proportionen und Abmessungen sind gewählt, um wesentliche Eigenschaften und Merkmale der Vorrichtung / des Verfahrens zu verdeutlichen; bei einer realisierten Vorrichtung können diese Proportionen und Abmessungen anders gewählt sein.

## Patentansprüche

1. Vorrichtung zum Übertragen elektronischer Bauteile von einem ersten Träger (68) zu einem zweiten bandförmigen Träger (74) mit:
- zumindest einem Schieber (12, 12a, 12b), der mit zumindest einem Schieber-Aktor (18) verbunden ist;
- einer Kappe (10) die eine Auflage (22), einen Schieberkanal (14) zur Aufnahme des zumindest einen Schiebers (12, 12a, 12b) und eine Greifereinrichtung (20) für den ersten Träger (68) aufweist;
- einer ersten Aufnahme (60) die dazu eingerichtet ist, den ersten Träger (68) an der Auflage (22) zu positionieren, wobei die elektronischen Bauteile (70, 70a) an einer von der Auflage (22) abgewandten Seite des ersten Trägers (68) vorgesehen sind;
- Aufnahme-Positionier- und/oder -Verschiebeaktoren (62, 64; 66) zum horizontalen Bewegen der ersten Aufnahme (60) relativ zu der Kappe (10);
- einer zweiten Aufnahme (72) die dazu eingerichtet ist, den zweiten Träger (74) zu positionieren;
- wobei die erste Aufnahme (60) und die zweite Aufnahme (72) so zueinander angeordnet sind, dass ein Spalt den ersten Träger (68) von dem zweiten Träger (74) trennt;
- die Kappe (10) dazu eingerichtet ist, aus einer ersten Position in eine zweite Position bewegt zu werden, so dass sich der Spalt zwischen dem ersten Träger (68) und dem zweiten Träger (74) verkleinert;
- einer Positioniereinrichtung (11) zum Positionieren der Kappe (10) und des zumindest einen Schiebers (12, 12a, 12b) relativ zu der ersten Aufnahme (60) sowie zu der zweiten Aufnahme (72), wobei die Positioniereinrichtung (11) einen Kappen-Positionieraktor (44) umfasst, um die mit der Positioniereinrichtung (11) verbundene Kappe (10) in vertikaler Richtung zu verschieben, wobei durch die vertikale Verschiebung sich der Abstand zwischen der Kappe (10) und dem ersten Träger (68) verändert; **dadurch gekennzeichnet, dass**
- der zumindest eine Schieber (12, 12a, 12b) dazu eingerichtet ist, von dem zumindest einen Schieber-Aktor (18) relativ zur Auflage (22) ausgefahren zu werden, den an der Auflage (22) anliegenden ersten Träger (68) von der Auflage (22) abzuheben, und ein auf dem ersten Träger (68) vorgesehenes elektronisches Bauteil (70a) in Richtung des zweiten Trägers (74) zu bewegen; und
- die Greifereinrichtung (20) dazu eingerichtet ist, den ersten Träger (68) zu der Auflage (22) zu fördern, um das elektronische Bauteil (70a) von dem ersten Träger (68) zu trennen.

2. Vorrichtung nach Anspruch 1 mit einer Steuereinheit (56) die dazu eingerichtet ist, die Ausfahrbewegung des zumindest einen Schiebers (12, 12a, 12b) zu beenden, sobald die Steuereinheit (56) erkennt, dass das elektronische Bauteil (70a) den zweiten Träger (74) oder einen auf den zweiten Träger aufgebrachten Klebstoff berührt.

3. Vorrichtung nach Anspruch 2 mit zumindest einem mit der Steuereinheit (56) verbundenem Sensorelement das dazu eingerichtet ist, eine von dem zumindest einem Schieber-Aktor (18) aufgenommene Leistung und / oder einen von dem zumindest einen Schieber (12, 12a, 12b) zurückgelegten Weg zu erfassen.

4. Vorrichtung nach einem der Ansprüche 1 bis 3, wobei die Greifereinrichtung (20) mit einer Unterdruckquelle verbunden ist.

5. Vorrichtung nach einem der vorhergehenden Ansprüche, wobei eine Beleuchtungseinrichtung (40) und eine Kameraeinrichtung (42) an einer Positioniereinrichtung (11) befestigt sind.

6. Vorrichtung nach einem der vorhergehenden Ansprüche, wobei ein Heizelement in einem zentralen Bereich der Auflage (22) oder an einer Positioniereinrichtung (11) vorgesehen ist.

7. Verfahren zum Übertragen eines elektronischen Bauteils (70a) von einem ersten Träger (68) zu einem zweiten bandförmigen Träger (74) mit den Schritten:
- Positionieren einer Kappe (10), eines ersten Trägers (68) und eines zweiten Trägers (74) relativ zueinander, so dass zumindest ein in einem Schieberkanal (14) der Kappe (10) vorgesehener Schieber (12, 12a, 12b), ein auf den ersten Träger (68) vorgesehenes elektronisches Bauteil (70a) sowie eine auf dem zweiten Träger (74) vorgesehene Kontaktfläche entlang einer gemeinsamen Achse ausgerichtet sind;
- Bewegen der Kappe (10) aus einer ersten Position in eine zweite Position, um einen Spalt zwischen dem ersten Träger (68) und dem zweiten Träger (74) zu verkleinern;
- Ausfahren des zumindest einen Schiebers (12, 12a, 12b) relativ zu einer Auflage (22) der Kappe und in Richtung des zweiten Trägers (74), so dass der an der Auflage (22) anliegende erste Träger (68) von der Auflage (22) abgehoben wird; **dadurch gekennzeichnet, dass** das Verfahren zusätzlich die folgenden Schritte umfasst:
- Trennen des elektronischen Bauteils (70a) von dem ersten Träger (68), indem eine in der Kappe (10) vorgesehene Greifereinrichtung (20) den ersten Träger (68) zur Auflage (22) fördert, und
- Ausfahren des zumindest einen Schiebers (12, 12a, 12b) um das auf dem ersten Träger (68) vorgesehene elektronische Bauteil (70a) in Richtung des zweiten Trägers (74) zu bewegen, bis eine Seite des elektronischen Bauteils (70a) den zweiten Träger (74) berührt.

8. Verfahren nach Anspruch 7, wobei der zumindest eine Schieber (12, 12a, 12b) relativ zur Auflage (22) und in Richtung des zweiten Trägers (74) ausgefahren wird, bis das am ersten Träger (68) vorgesehene elektronische Bauteil (70a) den zweiten Träger (74) oder einen auf den zweiten Träger (74) aufgebrachten Klebstoff berührt.

9. Verfahren nach einem der Ansprüche 7 oder 8, wobei nach dem Trennen des elektronischen Bauteils (70a) von dem ersten Träger (68) die Kappe (10) von der zweiten Position in die erste Position bewegt wird.

10. Verfahren nach Anspruch 9, wobei während der Bewegung der Kappe (10) in die erste Position der zumindest eine Schieber (12, 12a, 12b) das auf den zweiten Träger (74) übertragene elektronische Bauteil berührt.

11. Verfahren nach Anspruch 9 oder 10, wobei der zumindest eine Schieber (12, 12a, 12b) eingefahren wird, nachdem die Kappe (10) die erste Position erreicht hat.

12. Verfahren nach einem der Ansprüche 7 bis 11, wobei die Greifereinrichtung (20) der erste Träger (68) mittels Unterdruck zur Auflage (22) fördert.

13. Verfahren nach Anspruch 12, wobei der erste Träger (68) am äußeren Rand der Auflage (22) zuerst angesaugt wird.

14. Verfahren nach einem der Ansprüche 7 bis 13, wobei zur Steuerung der Bewegung des zumindest einen Schiebers (12, 12a, 12b) die von einem Schieber-Aktor (18) aufgenommene Leistung erfasst wird und / oder ein von dem zumindest einen Schieber (12, 12a, 12b) zurückgelegter Weg erfasst wird.

15. Verfahren nach Anspruch 14, wobei das Ausfahren des zumindest einen Schiebers (12, 12a, 12b) beendet wird, wenn die von dem Schieber-Aktor (18) aufgenommene Leistung und / oder der von dem zumindest einen Schieber (12, 12a, 12b) zurückgelegte Weg einen Schwellenwert überschreitet.

## Claims

1. Device for transferring electronic components from a first carrier (68) to a second, strip-shaped carrier (74), having:
- at least one slide (12, 12a, 12b), which is connected to at least one slide-actuator (18);
- a cap (10) which comprises a support (22), a slide channel (14) for receiving the at least one slide (12, 12a, 12b), and a gripping device (20) for the first carrier (68);
- a first receiver (60), which is configured to position the first carrier (68) on the support (22), the electronic components (70, 70a) being provided on a side of the first carrier (68) that is remote from the support (22);
- receiver-positioning and/or slide-actuators (62, 64; 66) for horizontally moving the first receiver (60) relative to the cap (10);
- a second receiver (72) which is configured to position the second carrier (74);
- wherein the first receiver (60) and the second receiver (72) are so arranged relative to one another that a gap separates the first carrier (68) from the second carrier (74);
- the cap (10) is configured to be moved from a first position into a second position so that the gap between the first carrier (68) and the second carrier (74) becomes smaller;
- a positioning device (11) for positioning of the cap(10) and of the at least one slide (12, 12a, 12b) relative to both the first receiver (60) and the second receiver (72), the positioning device (11) comprising a cap-positioning actuator (44) to slide the cap (10) connected to the positioning device (11) in vertical direction, the vertical slide changing the distance between the cap (10) and the first carrier (68);
**characterized in that**
- the at least one slide (12, 12a, 12b) is configured to be extended by the at least one slide-actuator (18) relative to the support (22), to lift the first carrier (68), which is resting against the support (22), off the support (22), and to move an electronic component (70a) provided on the first carrier (68) in the direction towards the second carrier (74); and
- the gripping device (20) is configured to convey the first carrier (68) to the support (22) in order to separate the electronic component (70a) from the first carrier (68).

2. Device according to claim 1 having a control unit (56) which is configured to terminate the extension movement of the at least one slide (12, 12a, 12b) as soon as the control unit (56) detects that the electronic component (70a) is in contact with the second carrier (74) or with an adhesive applied to the second carrier.

3. Device according to claim 2 having at least one sensor element connected to the control unit (56), which sensor element is configured to detect a power consumed by the at least one slide-actuator (18) and/or a distance covered by the at least one slide (12, 12a, 12b).

4. Device according to any one of claims 1 to 3, wherein the gripping device (20) is connected to a vacuum source.

5. Device according to any one of the preceding claims, wherein an illuminating device (40) and a camera device (42) are fastened to a positioning device (11).

6. Device according to any one of the preceding claims, wherein a heating element is provided in a central region of the support (22) or on a positioning device (11).

7. Method for transferring an electronic component (70a) from a first carrier (68) to a second, strip-shaped carrier (74), comprising the steps:
- positioning a cap (10), a first carrier (68) and a second carrier (74) relative to one another so that at least one slide (12, 12a, 12b) provided in a slide channel (14) of the cap (10), an electronic component (70a) provided on the first carrier (68), and a contact face provided on the second carrier (74) are oriented along a common axis;
- moving the cap (10) from a first position into a second position in order to make a gap between the first carrier (68) and the second carrier (74) smaller;
- extending the at least one slide (12, 12a, 12b) relative to a support (22) of the cap and in the direction towards the second carrier (74) so that the first carrier (68), which is resting against the support (22), is lifted off the support (22); **characterized in that** the method additionally comprises the following steps:
- separating the electronic component (70a) from the first carrier (68), which is effected by a gripping device (20) provided in the cap (10) conveying the first carrier (68) to the support (22), and
- extending the at least one slide (12, 12a, 12b) in order to move the electronic component (70a) provided on the first carrier (68) in direction of the second carrier (74) until one side of the electronic component (70a) is in contact with the second carrier (74).

8. Method according to claim 7, wherein the at least one slide (12, 12a, 12b) is extended relative to the support (22) and in the direction towards the second carrier (74) until the electronic component (70a) provided on the first carrier (68) is in contact with the second carrier (74) or with an adhesive applied to the second carrier (74).

9. Method according to either claim 7 or claim 8, wherein, after the electronic component (70a) has been separated from the first carrier (68), the cap (10) is moved from the second position into the first position.

10. Method according to claim 9, wherein, during the movement of the cap (10) into the first position, the at least one slide (12, 12a, 12b) is in contact with the electronic component transferred to the second carrier (74).

11. Method according to claim 9 or 10, wherein the at least one slide (12, 12a, 12b) is retracted once the cap (10) has reached the first position.

12. Method according to any one of claims 7 to 11, wherein the gripping device (20) conveys the first carrier (68) to the support (22) by means of a vacuum.

13. Method according to claim 12, wherein the first carrier (68) is first drawn in at the outside edge of the support (22).

14. Method according to any one of claims 7 to 13, wherein, in order to control 15 the movement of the at least one slide (12, 12a, 12b), the power consumed by a slide-actuator (18) is detected and/or a distance covered by the at least one slide (12, 12a, 12b) is detected.

15. Method according to claim 14, wherein the extension of the at least one slide (12, 12a, 12b) is terminated when the power consumed by the slide-actuator (18) and/or the distance covered by the at least one slide (12, 12a, 12b) exceeds a threshold value.

## Revendications

1. Dispositif permettant de transférer des composants électroniques d'un premier support (68) à un deuxième support (74) en forme de bande, comprenant :
- au moins un coulisseau (12, 12a, 12b) qui est relié à au moins un actionneur de coulisseau (18),
- un capot (10) qui présente un appui (22), un conduit de coulisseau (14) destiné à recevoir ledit au moins un coulisseau (12, 12a, 12b) et un dispositif de préhension (20) pour le premier support (68),
- un premier logement (60) qui est conçu pour positionner le premier support (68) sur l'appui (22), les composants électroniques (70, 70a) étant prévus sur une face du premier support (68) opposée à l'appui (22),
- des actionneurs de positionnement et/ou de déplacement de logement (62, 64; 66) permettant de déplacer horizontalement le premier logement (60) par rapport au capot (10),
- un deuxième logement (72) qui est conçu pour positionner le deuxième support (74),
- le premier logement (60) et le deuxième logement (60) étant disposés l'un par rapport à l'autre de telle manière qu'un intervalle sépare le premier support (68) du deuxième support (74),
- le capot (10) étant conçu pour être déplacé d'une première position dans une deuxième position de sorte que l'intervalle entre le premier support (68) et le deuxième support (74) peut être réduit,
- un dispositif de positionnement (11) pour positionner le capot (10) et ledit au moins un coulisseau (12, 12a, 12b) par rapport au premier logement (60) et au deuxième logement (72), ce dispositif de positionnement (11) comportant un actionneur de positionnement de capot (44) pour déplacer dans la direction verticale le capot (10) relié au dispositif de positionnement (11), le déplacement vertical modifiant l'intervalle entre le capot (10) et le premier support (68), **caractérisé en ce que**
- ledit au moins un coulisseau (12, 12a, 12b) est conçu pour être sorti par ledit au moins un actionneur de coulisseau (18) par rapport à l'appui (22), pour faire s'écarter de l'appui (72) le premier support (68) contigu à l'appui (22) et se déplacer un composant (70a) électronique prévu sur le premier support (68) dans la direction du deuxième support (74), et
- le dispositif de préhension (20) est conçu pour amener le premier support (68) vers l'appui (22) afin de séparer le composant électronique (70a) du premier support (68).

2. Dispositif selon la revendication 1, comprenant une unité de commande (56) conçue pour arrêter le mouvement de sortie dudit au moins un coulisseau (12, 12a, 12b) dès que l'unité de commande (56) reconnaît que le composant électronique (70a) entre en contact avec le deuxième support (74) ou avec une colle appliquée sur le deuxième support.

3. Dispositif selon la revendication 2, comprenant au moins un élément de détection qui est relié à l'unité de commande (56) et conçu pour détecter une puissance absorbée par ledit au moins un actionneur de coulisseau (18) et / ou une distance parcourue par ledit au moins un coulisseau (12, 12a, 12b).

4. Dispositif selon l'une des revendications 1 à 3, le dispositif de préhension (20) étant relié à une source de vide.

5. Dispositif selon l'une des revendications précédentes, un dispositif d'éclairage (40) et un système de caméra (42) étant fixés sur un dispositif de positionnement (11).

6. Dispositif selon l'une des revendications précédentes, un élément chauffant étant prévu dans une zone centrale de l'appui (22) ou sur un dispositif de positionnement (11).

7. Procédé pour transférer un composant électronique (70a) d'un premier support (68) à un deuxième support (74) en forme de bande, comprenant les étapes suivantes :
- le positionnement d'un capot (10), d'un premier support (68) et d'un deuxième support (74) les uns par rapport aux autres de sorte qu'au moins un coulisseau (12, 12a, 12b) prévu dans un conduit de coulisseau (14) du capot (10), un composant électronique (70a) prévu sur le premier support (68) et une surface de contact prévue sur le deuxième support (74) sont alignés le long d'un axe commun,
- le déplacement du capot (10) d'une première position dans une deuxième position afin de réduire un intervalle entre le premier support (68) et le deuxième support (74),
- la sortie dudit au moins un coulisseau (12, 12a, 12b) par rapport à un appui (22) du capot et dans la direction du deuxième support (74) de sorte que le premier support (68) contigu à l'appui (22) est écarté de l'appui (22), **caractérisé en ce que** le procédé comporte par ailleurs les étapes suivantes :
- la séparation du composant électronique (70a) du premier support (68) par le déplacement du premier support (68) vers l'appui (22) à l'aide du dispositif de préhension (20) prévu dans le capot (10), et
- la sortie dudit au moins un coulisseau (12, 12a, 12b) afin de faire se déplacer le composant électronique (70a) prévu sur le premier support (68) vers le deuxième support (74) jusqu'à ce qu'une face du composant électronique (70a) entre en contact avec le deuxième support (74).

8. Procédé selon la revendication 7, ledit au moins un coulisseau (12, 12a, 12b) étant sorti par rapport à l'appui (22) et dans la direction du deuxième support (74) jusqu'à ce que le composant électronique (70a) prévu sur le premier support (68) entre en contact avec le deuxième support (74) ou avec une colle appliquée sur le deuxième support (74).

9. Procédé selon l'une des revendications 7 ou 8, le capot (10) étant déplacé de la deuxième dans la première position une fois le composant électronique (70a) séparé du premier support (68).

10. Procédé selon la revendication 9, ledit au moins un coulisseau (12, 12a, 12b) entrant en contact avec le composant électronique (70a) transféré sur le deuxième support (74) pendant le déplacement du capot (10) dans la première position.

11. Procédé selon la revendication 9 ou 10, ledit au moins un coulisseau (12, 12a, 12b) étant rentré après que le capot (10) a atteint la première position.

12. Procédé selon l'une des revendications 7 à 11, le dispositif de préhension (20) amenant au moyen de vide le premier support (68) vers l'appui (22).

13. Procédé selon la revendication 12, le premier support (68) étant tout d'abord aspiré au bord extérieur de l'appui (22).

14. Procédé selon l'une des revendications 7 à 13, la puissance absorbée par un actionneur de coulisseau (18) et / ou une distance parcourue par ledit au moins un coulisseau (12, 12a, 12b) étant détectés afin de commander le mouvement dudit au moins un coulisseau (12, 12a, 12b).

15. Procédé selon la revendication 14, la sortie dudit au moins un coulisseau (12, 12a, 12b) étant arrêtée lorsque la puissance absorbée par l'actionneur de coulisseau (18) et / ou la distance parcourue par ledit au moins un coulisseau (12, 12a, 12b) excèdent une valeur seuil.
